# EUROPÄISCHE PATENTANMELDUNG

(11) **EP 1 069 680 A2**
(43) Veröffentlichungstag der Anmeldung: **17.01.2001**
(21) Anmeldenummer: 00202344.8
(22) Anmeldetag: 04.07.2000
(51) Int. Cl.: H03J 5/24

(54) **Tuner mit wenigstens einem ersten und einem zweiten Frequenzband**

(30) Priorität: 13.07.1999 DE 19932563
(71) Anmelder: Philips Corporate Intellectual Property GmbH, 52064 Aachen (DE); Koninklijke Philips Electronics N.V., 5621 BA Eindhoven (NL)
(72) Erfinder: Van der Wijst, Henk, 52064 Aachen (DE)
(74) Vertreter: Volmer, Georg, Dipl.-Ing.

(57) **Zusammenfassung**

Die Erfindung bezieht sich auf einen Tuner mit wenigstens einem ersten und einem zweiten Frequenzband und mit Mitteln zur Bandumschaltung zwischen den Frequenzbändern, wobei der Tuner einen Signaleingang zum Zuführen eines Frequenzinformationssignals aufweist.

Die Erfindung ist dadurch gekennzeichnet, daß der Tuner eine Bandauswahlschaltung aufweist, welche zur Auswahl und Ansteuerung jeweils eines Frequenzbandes vorgesehen ist und daß der Tuner zum Abstimmen auf eine Frequenz eine Frequenzsuchschaltung aufweist, welche in einem ersten Schritt zur Überprüfung der Abstimmbarkeit der Frequenz in dem ersten Frequenzband vorgesehen ist und, falls die Abstimmung in dem ersten Frequenzband nicht möglich ist, in einem zweiten Schritt zur Überprüfung der Abstimmbarkeit der Frequenz in dem zweiten Frequenzband vorgesehen ist.

## Beschreibung

Die Erfindung bezieht sich auf einen Tuner mit wenigstens einem ersten und einem zweiten Frequenzband und mit einem Signaleingang zum Zuführen eines Frequenzinformationssignals.

Die Erfindung bezieht sich ferner auf eine integrierte Schaltung mit einem PLL-Schaltkreis zur Steuerung eines wenigstens ein erstes und ein zweites Frequenzband aufweisenden Tuners.

Ein derartiger Tuner und eine derartige integrierte Schaltung sind beispielsweise von dem Tuner UV 316 der Firma Philips bekannt. Dieser bekannte Tuner wird nach dem WSP-Standard (World Standard Pinning) gefertigt. Der WSP-Standard legt die mechanischen Dimensionen, die Funktionen der einzelnen Anschlusspins des Tuners sowie die Antennenhöhe fest. Terrestrische Tuner weisen üblicherweise zwei oder drei Frequenzbänder auf, welche jeweils aus einem abstimmbaren Eingangsfilter, einem regelbaren Verstärker, einem abstimmbaren Bandpassfilter und einer Mischerschaltung bestehen. Für die Ansteuerung und Auswahl der Frequenzbänder sind in der WSP drei Pins zur Zuführung jeweils eines Steuersignals vorgesehen. Die Ansteuerung des Tuners erfolgt mittels des Mikroprozessors des Fernsehgerätes, welcher beispielsweise mittels eines I²C-Busses mit dem Tuner gekoppelt ist. Zur Auswahl des Frequenzbandes ist in bekannten Fernsehgeräten eine Tabelle abgespeichert, mittels derer den auswählbaren Frequenzen des Fernsehsignals das jeweils zugehörige Frequenzband des Tuners zuordbar ist. Wenn der Benutzer des Fernsehgerätes eine Fernsehsignalfrequenz auswählt, beispielsweise mittels einer Bedieneinheit, so wählt der Mikroprozessor des Fernsehers mittels der Tabelle das zugehörige Frequenzband des Tuners aus und sendet die die Bandauswahl bestimmenden Steuersignale an den Tuner.

Die Auswahl der Frequenzbander des Tuners mittels des Mikroprozessors des Fernsehgerätes hat den Nachteil, daß in dem Fernsehgerät nur Tuner einsetzbar sind, deren Frequenzbänder den in der Tabelle des Fernsehers abgespeicherten Werten entsprechen. Eine nachträgliche Änderung des Tuners hinsichtlich der Charakteristik der Frequenzbänder bzw. die Verwendung eines anderen Tuners ist nicht mehr möglich.

Es ist Aufgabe der Erfindung, einen Tuner sowie eine integrierte Schaltung der eingangs genannten Art zu schaffen, welche universell einsetzbar sind.

Diese Aufgabe ist für den Tuner erfindungsgemäß dadurch gelöst, daß der Tuner eine Bandauswahlschaltung aufweist, welche zur Auswahl und Ansteuerung jeweils eines Frequenzbandes vorgesehen ist und daß der Tuner zum Abstimmen auf eine Frequenz eine Frequenzsuchfunktion aufweist, welche in einem ersten Schritt zur Überprüfung der Abstimmbarkeit der Frequenz in dem ersten Frequenzband vorgesehen ist und, falls die Abstimmung in dem ersten Frequenzband nicht möglich ist, in einem zweiten Schritt zur Überprüfung der Abstimmbarkeit der Frequenz in dem zweiten Frequenzband vorgesehen ist.

Der erfindungsgemäße Tuner wertet somit das ihm von dem Mikroprozessor des Fernsehgerätes zugeführte Frequenzinformationssignal aus und wählt in Abhängigkeit dieses Frequenzinformationssignals das Frequenzband eigenständig aus. Um dem Tuner die eigenständige Auswahl des Frequenzbandes zu ermöglichen, weist dieser eine Frequenzsuchfunktion auf. Diese Frequenzsuchfunktion ist dazu vorgesehen, nacheinander in wenigstens zwei verschiedenen Frequenzbändern zu überprüfen, ob eine gewünschte Frequenz in dem jeweiligen Frequenzband abstimmbar ist.

Jedes Frequenzband weist eine Mischerschaltung mit einem Oszillator zur Ansteuerung des Mischers auf. Der Oszillator weist vorzugsweise jeweils einen Schwingkreis mit einer steuerbaren Kapazität auf. Die steuerbare Kapazität ist vorzugsweise als eine in Sperrichtung gepolte Kapazitätsdiode (Varicap-Diode) realisierbar, deren Kapazität von der angelegten Sperrspannung abhängig ist. Mittels Veränderung der Sperrspannung und der damit verbundenen Veränderung der Kapazität läßt sich die Oszillatorfrequenz des Schwingkreises steuern. Terrestrische Tuner sind üblicherweise zur Umsetzung von Eingangsfrequenzen in einem Bereich von 45 MHz bis 863 MHz vorgesehen. Da der steuerbare bzw. einstellbare Kapazitätsbereich der Varicap-Dioden begrenzt ist, weisen die Tuner vorzugsweise drei Frequenzbänder mit jeweils einem Oszillatorschwingkreis und jeweils einer zur Abstimmung des Oszillatorschwingkreises vorgesehenen Kapazitätsdiode auf. Unter Überprüfung auf Abstimmbarkeit wird somit verstanden, daß überprüft wird, ob der Oszillator des jeweiligen Frequenzbandes auf die gewünschte, zur Mischung auf die Zwischenfrequenz des Tuners erforderliche Frequenz abgestimmt werden kann. Die Oszillatorschwingkreise sind vorzugsweise mittels einer programmierbaren Teilerschaltung mit einem Quarzoszillator gekoppelt. Zur Synchronisation des Oszillatorschwingkreises mit dem Quarzoszillator ist vorzugsweise eine Phasenregelschaltung (PLL) vorgesehen. Die Überprüfung, ob eine gewünschte Frequenz in einem der Frequenzbänder abstimmbar ist, kann mittels eines Einrastdetektors erfolgen, welcher detektiert, ob die Phasenregelschaltung einrastet, d.h. ob die gewünschte Oszillatorschwingfrequenz des Oszillatorschwingkreises mit der Referenzfrequenz des Quarzoszillators synchronisierbar ist, wobei zwischen Oszillatorschwingkreis und Quarzoszillator eine programmierbare Teilerschaltung vorgesehen ist.

Die einzelnen Frequenzbänder weisen üblicherweise jeweils ein Bandpassfilter auf, welches von einer Spule und einer dazu parallel geschalteten Kapazitätsdiode gebildet wird. Die Sperrschichtkapazität der Kapazitatsdiode ist abhängig von der angelegten Sperrspannung und läßt sich daher durch Veränderung der angelegten Sperrspannung steuern. Die Kapazitätsdioden der Bandpassfilter und die Kapazitatsdioden der Oszillatorschwingkreise werden bei der Abstimmung vorzugsweise parallel angesteuert.

Wenn dem Tuner ein Frequenzinformationssignal einer gewünschten Frequenz zugeführt wird, wird in einem ersten Schritt die Oszillatorfrequenz des Oszillators des ersten Frequenzbandes von der unteren Bandfrequenz zu der oberen Bandfrequenz hin verstimmt. Dabei wird überprüft, ob die gewünschte Frequenz in dem ersten Frequenzband abstimmbar ist. Wenn die gewünschte Frequenz in dem ersten Frequenzband nicht abgestimmt werden konnte, erfolgt automatisch ein Umschalten auf das zweite Frequenzband, dessen Oszillator nun ebenfalls zur Abstimmung auf die gewünschte Frequenz kontinuierlich von der unteren Bandgrenze zu der oberen Bandgrenze hin verstimmt wird.

Dieses Prinzip kann auch bei Tunern mit drei oder mehr Frequenzbändern angewendet werden, wobei beispielsweise bei drei Frequenzbändern die Abstimmung zunächst in dem ersten, dann in dem Zweiten und schließlich in dem dritten Frequenzband versucht wird.

Die eigenständige Bandauswahl des Tuners mittels der Bandauswahlschaltung und der Frequenzsuchfunktion hat den Vorteil, daß ein derartig ausgebildeter Tuner in jedem beliebigen Fernsehgerät einsetzbar ist. Hierzu muß weder die Software des Mikroprozessors des Fernsehgerätes noch die Software des Tuners verändert werden. Ein derartiger Tuner läßt sich daher mit sehr hohen Stückzahlen effizient und kostengünstig produzieren. Außerdem ist es möglich, die physikalischen Parameter der einzelnen Frequenzbänder zu verändern, ohne daß eine Änderung der Software des Tuners erforderlich ist. Beispielsweise können die Bandgrenzen der Frequenzbänder durch Verwendung anderer Kapazitätsdioden oder anderer Induktivitäten für die jeweiligen Bandpässe und Oszillatorschwingkreise verschoben werden. In einem derartigen Fall ist keine Veränderung der Software des Tuners erforderlich, da der Tuner automatisch die Umschaltpunkte zwischen den einzelnen Frequenzbändern verändert.

Mittels der vorteilhaften Ausgestaltung der Erfindung nach Anspruch 2 läßt sich ein unnötiges Umschalten zwischen den Frequenzbändern vermeiden. Entsprechend der mittels der Frequenzdifferenzermittlungsschaltung ermittelten Differenzfrequenz zwischen dem alten und dem neuen Frequenzinformationssignal, welches dem Tuner beispielsweise von dem Mikroprozessor des Fernsehers zugeführt wird, bestimmt die Bandauswahlschaltung einen Tune-Modus. Dieser Tune-Modus beeinflußt die weitere Bandauswahl, d.h. er bestimmt, ob und unter welchen Bedingungen eine Bandumschaltung zwischen den Frequenzbändern erfolgt.

Gemäß Anspruch 4 können als Tune-Modi beispielsweise ein Erneuerungsmodus und/oder ein automatischer Frequenzregelungsmodus und/oder ein Suchmodus und/oder ein Kanalneuwahlmodus mittels der Frequenzdifferenzermittlungsschaltung unterschieden werden. Im Erneuerungsmodus wird erkannt, daß der Mikroprozessor des Fernsehers dasselbe Frequenzinformationssignal nochmals an den Tuner gesandt hat. In einem solchen Fall ist eine Bandumschaltung nicht erwünscht und daher ist im Erneuerungsmodus keine Bandumschaltung vorgesehen. Im automatischen Frequenzregelungsmodus erkennt die Frequenzdifferenzermitttungsschaltung, daß sich das dem Tuner zugeführte Frequenzinformationssignal nur sehr geringfügig von dem alten Frequenzinformationssignal unterscheidet. Dies ist charakteristisch für den automatischen Frequenzregelungsmodus eines Fernsehers. Bei einem derartigen automatischen Frequenzregelungsmodus erzeugt der Zwischenfrequenzdemodulator ein Steuersignal zur Frequenzfeinabstimmung, welches an den Mikroprozessor des Fernsehers geliefert wird. Der Mikroprozessor des Fernsehers liefert dann ein geringfügig geändertes Frequenzinformationssignal an den Tuner. Mittels der Frequenzdifferenzermittlungsschaltung läßt sich ein derartiger Fall erkennen und eine störende Bandumschaltung verhindern. Als weiterer Tune-Modus ist vorteilhaft ein Suchmodus mittels der Frequenzdifferenzermittlungsschaltung erkennbar. Fernsehgeräte weisen einen derartigen Suchmodus auf, um die einzelnen Frequenzbänder systematisch nach empfangbaren Fernsehkanälen zu durchsuchen. In einem solchen Fall erhöht der Mikroprozessor des Fernsehers das dem Tuner zugeführte Frequenzinformationssignal kontinuierlich in vorgebbaren Frequenzschritten. Bei Erkennung eines empfangbaren Kanals können die Frequenzdaten dieses Kanals automatisch oder manuell abgespeichert werden. Wird von dem Mikroprozessor des Fernsehers ein derartiger Suchmodus durchgeführt, so ist eine Frequenzbandumschaltung nur gewünscht, wenn das Ende des jeweiligen Frequenzbandes erreicht ist. Im Suchmodus des Tuners ist daher eine Frequenzbandänderung nur bei Erreichen des Frequenzbandendes vorgesehen. Ferner ist mittels der Frequenzdifferenzermittlungsschaltung vorteilhaft ein Kanalneuwahlmodus unterscheidbar. Im Kanalneuwahlmodus erkennt die Bandauswahlschaltung, daß dem Tuner ein Frequenzinformationssignal zugeführt wird, welches einem neuen Kanal entspricht. Dies wird dadurch erkannt, daß die Frequenzdifferenz zwischen dem alten und dem neuen Frequenzinformationssignal einen vorgebbaren Mindestabstand überschreitet. Die Frequenzbandeinstellung erfolgt im Kanalneuwahlmodus mittels der Frequenzsuchfunktion, mittels derer zunächst überprüft wird, ob die dem gewünschten Kanal zugeordnete Frequenz in dem ersten Frequenzband abstimmbar ist. Ist dies nicht möglich, wird in einem zweiten Schritt die Abstimmung in dem zweiten Frequenzband versucht. Die Bandumschaltung zwischen dem ersten und dem zweiten Frequenzband erfolgt bei Erreichen des Bandendes automatisch. Die für den Suchmodus charakteristische Frequenzdifferenz liegt oberhalb der Frequenzdifferenz des automatischen Frequenzregelungsmodus und unterhalb der Frequenzdifferenz des Kanalneuwahlmodus.

Gemäß Anspruch 3 weist die Bandauswahlschaltung zum Einstellen eines neuen Kanals, d.h. im Kanalneuwahlmodus, eine Bandvorwahlschaltung auf. Diese Bandvorwahlschaltung teilt die dem Tuner zugeführten Frequenzinformationssignale in eindeutige und nicht eindeutige Frequenzinformationssignale auf. Im Falle eindeutiger Frequenzinformationssignale trifft die Bandvorwahlschaltung eine eindeutige und endgültige Entscheidung über das dem Frequenzinformationssignal zugeordnete Frequenzband. Im Falle mehrdeutiger Frequenzinformationssignale wird mittels der Frequenzsuchfunktion in einem ersten Schritt überprüft, ob die dem gewünschten Kanal zugeordnete Frequenz in dem ersten Frequenzband abstimmbar ist. Falls der gewünschte Kanal in dem ersten Frequenzband nicht abstimmbar ist, schaltet der Tuner automatisch auf das zweite Frequenzband um und überprüft, ob der gewünschte Kanal in dem zweiten Frequenzband abstimmbar ist.

Bei der vorteilhaften Ausgestaltung der Bandvorwahlschaltung gemäß Anspruch 5 teilt die Bandvorwahlschaltung die Frequenzinformationssignale der wenigstens zwei Frequenzbänder in wenigstens zwei Gruppen ein. Die erste Gruppe umfaßt die Frequenzinformationssignale, die eindeutig dem ersten Frequenzband zugeordnet werden können sowie die Frequenzinformationssignale, deren zugehöriges Empfangssignal sowohl in dem ersten als auch in dem zweiten Frequenzband liegen könnte. Die zweite Gruppe umfaßt diejenigen Frequenzinformationssignale, deren zugehöriges Empfangssignal eindeutig in dem zweiten Frequenzband liegen muß. Daher ist eine eventuelle Frequenzbandumschaltung nur im Bereich der ersten Gruppe erforderlich. Stellt die Bandvorwahlschaltung fest, daß ein Frequenzinformationssignal in der ersten Gruppe liegt, so wird zunächst überprüft, ob die Frequenz in dem ersten Frequenzband abstimmbar ist. Wenn die gewünschte Frequenz in dem ersten Frequenzband nicht abstimmbar ist, schaltet der Tuner automatisch auf das zweite Frequenzband um und versucht die Abstimmung in dem zweiten Frequenzband. Bei der zweiten Gruppe von Frequenzinformationssignalen wird sofort auf das zweite Frequenzband geschaltet und es ist keine automatische Bandumschaltung vorgesehen.

Eine alternative Aufteilung der Frequenzinformationssignale in drei Gruppen ist gemäß Anspruch 6 vorgesehen. Dabei umfaßt die erste Gruppe diejenigen Frequenzinformationssignale, die eindeutig dem ersten Frequenzband zuordbar sind und die dritte Gruppe diejenigen Frequenzinformationssignale, die eindeutig dem zweiten Frequenzband zuordbar sind. Dazwischen ist eine zweite Gruppe von Frequenzinformationssignalen vorgesehen, deren zugeordnete Frequenzsignale sich sowohl in dem ersten als auch in dem zweiten Frequenzband des Tuners befinden könnten. In der ersten und der dritten Gruppe ist daher keine automatische Bandumschaltung mittels der Frequenzsuchfunktion vorgesehen. In der mittleren zweiten Gruppe wird dagegen zunächst in dem ersten Frequenzband überprüft, ob ein dem Frequenzinformationssignal zugeordnetes Frequenzsignal abstimmbar ist und bei erfolglosem Versuch in dem ersten Frequenzband wird automatisch auf das zweite Frequenzband umgeschaltet.

Bei der vorteilhaften Ausgestaltung der Erfindung nach Anspruch 7 wird die an den Kapazitätsdioden der jeweiligen Bandpassfilter und der jeweiligen Oszillatorschwingkreise angelegte Sperrspannung (Tune-Spannung) mittels eines Bandendedetektors ausgewertet. Dieser Bandendedetektor vergleicht die Tune-Spannung mit einem vorgebbaren Schwellwert und liefert bei Überschreiten dieses Schwellwertes ein Steuersignal. Der Tuner schaltet dann automatisch auf das nächste Frequenzband um und versucht die gewünschte Frequenz in dem nächsten Frequenzband abzustimmen.

Das Umschalten zwischen den einzelnen Frequenzbändern kann vorteilhaft mittels der Ausgestaltung nach Anspruch 8 realisiert werden. Bei dieser Ausgestaltung weist die Bandauswahlschaltung ein zylklisches Schieberegister mit n-Elementen auf, wobei n der Anzahl der Frequenzbänder des Tuners entspricht. So ist beispielsweise bei einem Tuner mit drei Frequenzbändern ein Schieberegister mit drei Elementen vorgesehen. Jedes dieser drei Elemente enthält eine Steuerinformation, vorzugsweise jeweils ein Bit, welches zur Ansteuerung jeweils eines der drei Frequenzbänder vorgesehen ist. Zwei der drei Elemente enthalten beispielsweise die Steuerinformation 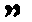 0", was bedeutet, daß das diesem Element zugeordnete Frequenzband nicht eingeschaltet werden soll. Eines der drei Elemente enthält jeweils die Steuerinformation 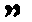 1", was bedeutet, daß das diesem Element zugeordnete Frequenzband eingeschaltet ist und in diesem Frequenzband eine Abstimmung auf die gewünschte Frequenz durchgeführt werden soll. Somit wird gewährleistet, daß immer nur eines der drei Frequenzbänder eingeschaltet ist und daß immer nur in einem der drei Frequenzbänder der Abstimmvorgang durchgeführt wird. Wenn der Bandendedetektor das Bandende des jeweiligen Frequenzbandes detektiert, so liefert er ein Steuersignal an das zyklische Schieberegister, wodurch die Steuerinformationen jeweils an das benachbarte Steuerelement weitergegeben werden. Dies bedeutet, daß das bisher eingeschaltete Frequenzband von dem vorhergehenden Steuerelement die Steuerinformation 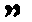 0" übernimmt und abgeschaltet wird. Die Steuerinformation 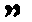 1" wird an das nachfolgende Steuerelernent weitergegeben, wodurch das dem nachfolgenden Steuerelement zugeordnete Frequenzbandes eingeschaltet wird und in diesem Frequenzband die Abstimmung auf die gewünschte Frequenz versucht wird.

Eine derartige Organisation der Frequenzbandumschaltung mittels eines Schieberegisters ist einfach realisierbar und sehr zuverlässig.

Das erste Frequenzband, welches bei der Einstellung eines neuen Kanals zunächst durchsucht wird, liegt gemäß Anspruch 9 vorzugsweise unterhalb des zweiten Frequenzbandes. Dies ist insbesondere vorteilhaft bei Tunern mit drei Frequenzbändern, bei denen die Bandumschaltung mittels eines Schieberegisters realisiert ist, da es bei Bandende ein einfaches Weiterschieben der Steuerinformationen ermöglicht.

Die erfindungsgemäßen Tuner sind vorzugsweise so konzipiert, daß im Grenzbereich zwischen zwei Frequenzbändern eine Überlappung vorgesehen ist, so daß in diesem Überlappungsbereich eine Frequenz sowohl in dem ersten Frequenzband als auch in dem zweiten Frequenzband abstimmbar ist. In dem Überlappungsbereich ist das Rauschen in dem niedrigeren Frequenzband geringer als in dem höheren Frequenzband und die Verstärkung ist in dem niedrigeren Frequenzband höher als in dem höheren Frequenzband. Daher ist es bei mehrdeutigen Frequenzinformationssignalen vorteilhaft, den Tune-Vorgang in dem niedrigeren Frequenzband zu beginnen und bei erfolgloser Abstimmung in dem niedrigeren Frequenzband auf das nächste höhere Frequenzband umzuschalten.

Die erfindungsgemäßen Tuner lassen sich vorzugsweise in Fernsehgeräten einsetzen.

Die Aufgabe der Erfindung ist für die integrierte Schaltung erfindungsgemäß dadurch gelöst, daß die integrierte Schaltung eine Bandauswahlschaltung aufweist, welche zur Lieferung von Steuersignalen zur Auswahl jeweils eines Frequenzbandes in Abhängigkeit des Frequenzinformationssignals vorgesehen ist und daß die Bandauswahlschaltung zum Abstimmen auf eine Frequenz eine Frequenzsuchfunktion aufweist, welche in einem ersten Schritt zur Überprüfung der Abstimmbarkeit der Frequenz in dem ersten Frequenzband vorgesehen ist und, falls die Abstimmung in dem ersten Frequenzband nicht möglich ist, in einem zweiten Schritt zur Überprüfung der Abstimmbarkeit der Frequenz in dem zweiten Frequenzband vorgesehen ist.

Eine derartige integrierte Schaltung kann für Tuner mit verschiedenen Frequenzbandaufteilungen verwendet werden, wobei keine Änderung der Software erforderlich ist. Eine derartige integrierte Schaltung kann daher in sehr großen Stückzahlen produziert werden.

Einige schematisch dargestellte Ausführungsbeispiele der Erfindung werden nachfolgend anhand der Zeichnung in den Fig. 1 bis 7 näher erläutert. Es zeigen:
- Fig. 1: ein schematisches Blockschaltbild eines Tuners mit drei Frequenzbändern,
- Fig. 2: die prinzipielle Funktionsweise eines Steuermechanismus zur automatischen Bandumschaltung zwischen den einzelnen Frequenzbändern mittels eines Schieberegisters,
- Fig. 3: den Verlauf der Tune-Spannungen der drei Frequenzbänder eines Dreibandtuners über der Frequenz, wobei zusätzlich die mittels einer Bandvorwahlschaltung vorgesehene Aufteilung des gesamten Frequenzbereiches des Tuners in drei eindeutige und zwei mehrdeutige Frequenzbandbereiche dargestellt ist,
- Fig. 4: die Tune-Spannung über der Frequenz gemäß Fig. 3, wobei zusätzlich die mittels einer Bandvorwahlschaltung vorgesehene Aufteilung des gesamten Frequenzbereiches des Tuners in zwei mehrdeutige und einen eindeutigen Frequenzbandbereich dargestellt ist,
- Fig. 5: ein prinzipielles Funktionsdiagramm der für die Auswahl des Frequenzbandes vorgesehenen Bandauswahlschaltung des Tuners,
- Fig. 6: ein Flußdiagramm des Vorgangs der Bandauswahl mittels der Bandauswahlschaltung,
- Fig. 7: ein prinzipielles Blockschaltbild der Bandauswahlschaltung.

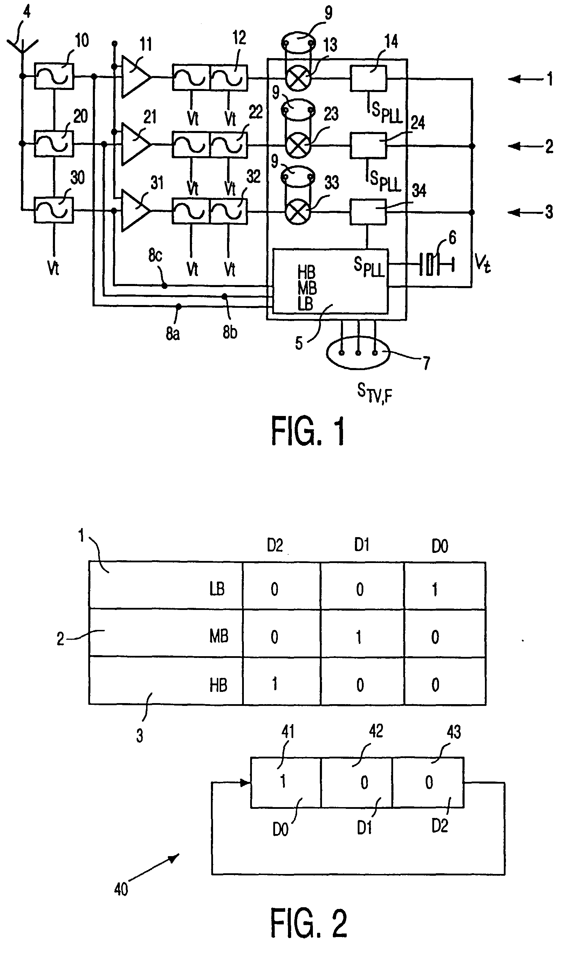

Fig. 1 zeigt das prinzipielle Blockschaltbild eines Tuners mit einem ersten Frequenzband 1, einem zweiten Frequenzband 2 und einem dritten Frequenzband 3. Das erste Frequenzband 1, das zweite Frequenzband 2 und das dritte Frequenzband 3 sind jeweils parallel geschaltet und mit einer Antenne 4 gekoppelt. Das erste Frequenzband 1 weist in Reihenschaltung ein abstimmbares Eingangsfilter 10, einen Verstärker 11, ein abstimmbares Bandpassfilter 12, einen Mischer 13 sowie einen abstimmbaren Oszillator 14 auf. Das zweite Frequenzband 2 weist in Reihenschaltung ein abstimmbares Eingangsfilter 20, einen Verstärker 21, ein abstimmbares Bandpassfilter 22, einen Mischer 23 und einen abstimmbaren Oszillator 24 auf.

Das dritte Frequenzband 3 weist in Serienschaltung ein abstimmbares Eingangsfilter 30, einen Verstärker 31, ein abstimmbares Bandpassfilter 32, einen Mischer 33 sowie einen abstimmbaren Oszillator 34 auf. Das von der Antenne 4 empfangene Empfangssignal wird parallel dem Eingangsfilter 10 des ersten Frequenzbandes 1, dem Eingangsfilter 20 des zweiten Frequenzbandes 2 und dem Eingangsfilter 30 des dritten Frequenzbandes 3 zugeführt. Zur Steuerung des Tuners ist eine integrierte Schaltung 5 vorgesehen, welche unter anderem eine nicht näher dargestellte PLL-Schaltung aufweist. Die integrierte Schaltung 5 ist mit einem Quarzoszillator 6 gekoppelt. Die integrierte Schaltung 5 liefert ein Steuersignal S_{PLL} an den Oszillator 14 des ersten Frequenzbandes 1, an den Oszillator 24 des zweiten Frequenzbandes 2 und an den Oszillator 34 des dritten Frequenzbandes 3. Außerdem liefert die integrierte Schaltung 5 eine Tune-Spannung Vₜ an den Oszillator 14, den Oszillator 24 und den Oszillator 34. Diese Tune-Spannung Vₜ steuert als Sperrschichtspannung die Sperrschichtkapazität der Kapazitätsdioden der abstimmbaren Filter und der abstimmbaren Oszillatoren. Die integrierte Schaltung 5 weist diverse Steuereingänge 7 auf mittels derer der integrierten Schaltung 5 beispielsweise über einen I²C-Bus Steuersignale S_{TV} und ein Frequenzinformationssignal F von dem Mikroprozessor eines Fernsehgerätes zuführbar sind. Die Tune-Spannung Vₜ wird von der integrierten Schaltung 5 ebenfalls an das Eingangsfilter 10 und das Bandpassfilter 12 des ersten Frequenzbandes 1, an das Eingangsfilter 20 und das Bandpassfilter 22 des zweiten Frequenzbandes 2 und an das Eingangsfilter 30 und das Bandpassfilter 32 des dritten Frequenzbandes 3 geliefert. Dadurch wird es möglich, eine parallele Abstimmung der Eingangsfilter, Bandpassfilter und Oszillatorschwingkreise des jeweiligen Frequenzbandes durchzuführen. Die integrierte Schaltung 5 ist mittels einer Steuerleitung 8a mit dem integrierten Verstärker 11, mittels einer Steuerleitung 8b mit dem Verstärker 21 und mittels einer Steuerleitung 8c mit dem Verstärker 31 gekoppelt. Die Steuerleitungen 8a, 8b und 8c sind zur Lieferung von Steuersignalen zur Bandauswahl des ersten, des zweiten oder des dritten Frequenzbandes vorgesehen. Mittels dieser Steuersignale sind der Verstärker 11, der Verstärker 21 und der Verstärker 31 jeweils einzeln an- und abschaltbar, wodurch jeweils eines der drei Frequenzbänder ausgewählt ist. Der Mischer 13 des ersten Frequenzbandes 1, der Mischer 23 des zweiten Frequenzbandes 2 und der Mischer 33 des dritten Frequenzbandes 3 weisen einen gemeinsamen Zwischenfrequenzausgang 9 auf. Dies ist in der Fig. 1 durch die gemeinsame Bezeichnung des Zwischenfrequenzausganges 9 für die drei Mischer dargestellt.

Zum Empfang eines von der Antenne 4 gelieferten Empfangssignals wird dem Tuner mittels der Steuereingänge 7 ein Frequenzinformationssignal F zugeführt. In Abhängigkeit dieses Frequenzinformationssignals F wählt die integrierte Schaltung 5 eines der drei Frequenzbänder 1, 2 oder 3 durch Anschaltung des Verstärkers 11 des ersten Frequenzbandes 1 oder des Verstärkers 21 des zweiten Frequenzbandes 2 oder des Verstärkers 31 des dritten Frequenzbandes 3 aus. Des weiteren werden an einen der drei Oszillatoren 14, 24 oder 34 PLL-Steuersignale S_{PLL} geliefert. Außerdem werden von der integrierten Schaltung 5 Tune-Spannungen Vₜ zur Abstimmung an die Oszillatoren 14, 24 und 34, an die Bandpassfilter 12, 22 und 32 sowie an die Eingangsfilter 10, 20 und 30 geliefert. Mittels der Steuersignale S_{PLL} und der Tune-Spannung Vt wird versucht, den jeweiligen Oszillatorschwingkreis des zur Abstimmung vorgesehenen Frequenzbandes auf die sich aus der gewünschten Empfangsfrequenz und der Zwischenfrequenz ergebende Oszillatorfrequenz abzustimmen. Mittels der Tune-Spannung Vₜ wird hierzu die Mittenfrequenz des Bandpassfilters des jeweils ausgewählten Frequenzbandes sowie die Oszillatorfrequenz der Schwingkreise des jeweiligen Oszillators von der unteren Frequenzbandgrenze zu der oberen Frequenzbandgrenze hin verschoben und überprüft, ob die gewünschte Frequenz mittels des Oszillators des jeweiligen Frequenzbandes einstellbar ist. Dies erfolgt vorzugsweise dadurch, daß mittels eines PLL-Einrastdetektors überwacht wird, ob die den Abstimmvorgang steuernde Phasenregelschaltung der integrierten Schaltung 5 einrastet.

Der Zwischenfrequenzausgang 9 ist mit einem nicht näher dargestellten Zwischenfrequenzdemodulator über ein Oberflächenwellenfilter gekoppelt. Der Zwischenfrequenzdemodulator ist außerdem zur Erzeugung eines Signals zur automatischen Verstärkungsregelung vorgesehen.

Die integrierte Schaltung 5 weist eine in Fig. 1 nicht näher dargestellte Bandauswahlschaltung auf, welche zur eigenständigen Auswahl eines der drei Frequenzbänder 1, 2 oder 3 in Abhängigkeit des der integrierten Schaltung 5 über die Steuereingänge 7 zugeführten Frequenzinformationssignals F vorgesehen ist. Eine erste Möglichkeit, eine derartige Bandauswahlschaltung auf einfache Art und Weise zu realisieren, ist als schematisches Funktionsprinzip in Fig. 2 dargestellt. Gemäß Fig. 2 sind zur Auswahl des ersten Frequenzbandes 1, des zweiten Frequenzbandes 2 oder des dritten Frequenzbandes 3 ein erstes Steuerbit D0, ein zweites Steuerbit D1 und ein drittes Steuerbit D2 vorgesehen. Das erste Steuerbit D0 ist zur Übertragung über die Steuerleitung 8a an den Verstärker 11 des erste Frequenzbandes 1, das zweite Steuerbit D1 zur Übertragung über die Steuerleitung 8b an den Verstärker 21 des zweiten Frequenzbandes 2 und das dritte Steuerbit D2 zur Übertragung über die Steuerleitung 8c an den Verstärker 31 des dritten Frequenzbandes 3 vorgesehen.

Für das vorliegende Beispiel soll das erste Frequenzband 1 das untere Frequenzband des Tuners sein. Dies wird nachfolgend als unteres Frequenzband LB (Low-Band) bezeichnet. Das zweite Frequenzband 2 soll nachfolgend das mittlere Frequenzband des Tuners sein. Es wird nachfolgend als mittleres Frequenzband MB (Mid-Band) bezeichnet. Das dritte Frequenzband 3 soll nachfolgend das obere Frequenzband des Tuners sein. Es wird als nachfolgend als oberes Frequenzband HB (High-Band) bezeichnet. Fig. 2 zeigt die Zuordnungstabelle zwischen den Werten der Steuerbits D0, D1 und D2 sowie dem jeweils ausgewählten Frequenzband LB, MB bzw. HB. Ist das erste Steuerbit D0 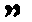 1" und das zweite Steuerbit D1 und das dritte Steuerbit D2 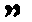 0", dann ist das untere Frequenzband LB ausgewählt und dementsprechend nur der Verstärker 11 des unteren Frequenzbandes LB eingeschaltet. Nimmt das zweite Steuerbit D1 den Wert 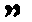 1" an, so wird das mittlere Frequenzband MB ausgewählt. Wenn das dritte Steuerbit D2 den Wert 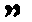 1" annimmt, so wird das obere Frequenzband HB ausgewählt. Die Bandumschaltung zwischen dem unteren Frequenzband LB, dem mittleren Frequenzband MB und dem oberen Frequenzband HB läßt sich vorzugsweise gemäß Fig. 2 mittels eines Schieberegisters 40 realisieren, welches ein erstes Speicherfeld 41, ein zweites Speicherfeld 42 und ein drittes Speicherfeld 43 aufweist. Das erste Speicherfeld 41 ist zur Speicherung des ersten Steuerbits D0 vorgesehen, das zweite Speicherfeld 42 zur Speicherung des zweiten Steuerbits D1 und das dritte Speicherfeld 43 zur Speicherung des dritten Steuerbits D2. Das erste Speicherfeld 41 weist die Steuerinformation 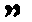 1", das zweite Speicherfeld 42 die Steuerinformation 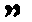 0" und das dritte Speicherfeld 43 die Steuerinformation 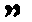 0" auf. Diese Konfiguration ist bei der vereinfachten Bandauswahlschaltung gemäß Fig. 2 zu Beginn eines Tune-Vorganges eingestellt. Wird dem Tuner daher ein neues Frequenzinformationssignal an den Steuereingängen 7 zugeführt, so wird mittels der Bandauswahlschaltung zunächst das untere Frequenzband LB eingeschaltet und der Tuner versucht, die gewünschte Frequenz in dem unteren Frequenzband LB abzustimmen. Falls dies nicht möglich ist, wird die in dem Schieberegister 40 gespeicherte Information jeweils ein Speicherfeld weiter geschoben, wodurch das zweite Speicherfeld 42 die Steuerinformation 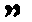 1" annimmt und wodurch das mittlere Frequenzband MB eingeschaltet wird. Nachfolgend versucht der Tuner, den Oszillator des mittleren Frequenzbandes MB auf die gewünschte Frequenz abzustimmen. Ist dies nicht möglich, so werden die Steuerinformationen des Schieberegisters erneut jeweils um einen Speicherplatz weiter geschoben, wodurch das dritte Speicherfeld 43 die Steuerinformation 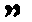 1" erhält und der Tuner auf das obere Frequenzband HB umschaltet. Schließlich wird nun in dem oberen Frequenzband HB versucht, den Oszillator dieses Frequenzbandes auf die gewünschte Frequenz abzustimmen. Die sukzessive Überprüfung des unteren Frequenzbandes LB, des mittleren Frequenzbandes MB und des oberen Frequenzbandes HB auf Abstimmbarkeit der gewünschten Frequenz verursacht für die Frequenzen, die sich in dem oberen Frequenzband HB befinden, relativ Lange Abstimm- bzw. Suchzeiten.

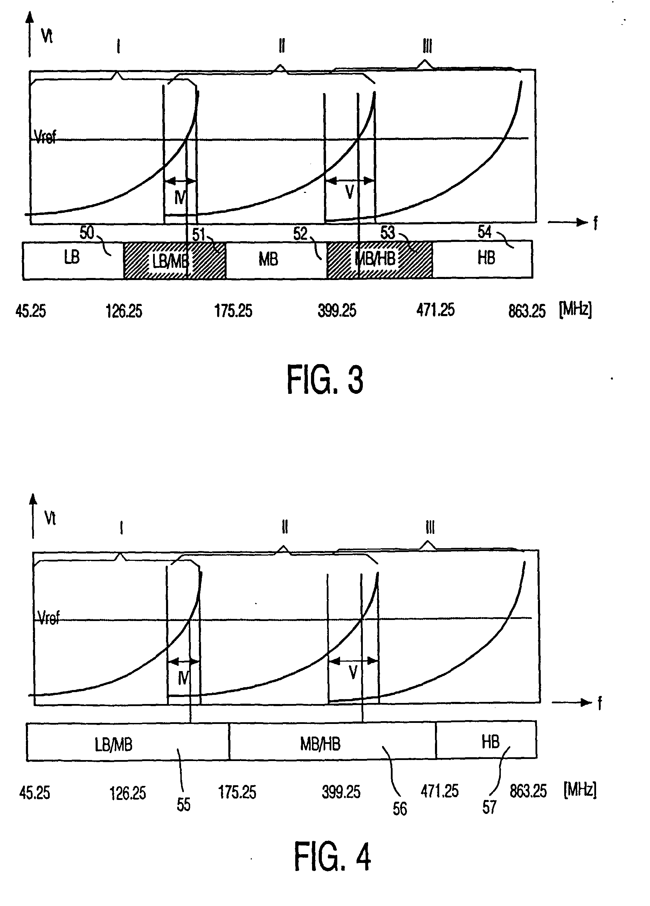

Eine vorteilhafte Ausgestaltung zur Verkürzung dieser Suchzeiten ist in Fig. 3 dargestellt. Fig. 3 zeigt die Tune-Spannung Vₜ, mittels derer die Kapazitätsdioden der Bandpässe 12, 22 und 32 und der Oszillatoren 14, 24 und 34 des Tuners gemäß Fig. 1 abstimmbar sind, über der Frequenz. Der Bereich I zeigt den Verlauf der Tune-Spannung Vₜ des ersten Frequenzbandes 1 über der Frequenz, der Bereich II den Verlauf der Tune-Spannung Vₜ des zweiten Frequenzbandes 2 über der Frequenz und der Bereich III den Verlauf der Tune-Spannung Vₜ des dritten Frequenzbandes 3. Der Bereich I und der Bereich II überlappen sich in einem Bereich IV. Der Bereich III und der Bereich II überlappen sich in einem Bereich V. In dem Überlappungsbereich IV kann eine Frequenz sowohl in dem ersten Frequenzband 1 als auch in dem zweiten Frequenzband 2 abgestimmt werden. In dem Überlappungsbereich V kann eine Frequenz sowohl in dem zweiten Frequenzband 2 als auch in dem dritten Frequenzband 3 abgestimmt werden.

Der gesamte Frequenzbereich aller terrestrischen Tuner, d.h. der Bereich, welcher die einzelnen Frequenzbandbereiche der Tuner aller Fernsehnormen umfaßt, erstreckt sich von 45,25 MHz bis 863,25 MHz. Gemäß Fig. 3 wird dieser gesamte Frequenzbandbereich mittels einer in der Fig. 3 nicht näher dargestellten Bandvorwahlschaltung in eine erste Gruppe 50, eine zweite Gruppe 51, eine dritte Gruppe 52, eine vierte Gruppe 53 und eine fünfte Gruppe 54 unterteilt. Die Bandvorwahlschaltung ist vorzugsweise in die integrierte Schaltung 5 gemäß Fig. 1 integriert. Die erste Gruppe 50 umfaßt den Frequenzbandbereich von 45,25 MHz bis 126,25 MHz, die zweite Gruppe 51 den Frequenzbandbereich von 126,25 MHz bis 175,25 MHz, die dritte Gruppe 52 den Frequenzbandbereich von 175,25 MHz bis 399,25 MHz, die vierte Gruppe 53 den Frequenzbandbereich von 399,25 MHz bis 471,25 MHz und schließlich die fünfte Gruppe 54 den Frequenzbandbereich von 471,25 MHz bis 863,25 MHz. Wird dem Tuner von dem Mikroprozessor des Fernsehers ein neues Frequenzinformationssignal zur Einstellung eines neuen Empfangskanals zugeführt, so trifft die Bandvorwahlschaltung eine Vorauswahl des Frequenzbandes anhand der in der Fig. 3 dargestellten Gruppen 50 bis 54. Der ersten Gruppe 50 ist eindeutig das untere Frequenzband LB, der zweite Gruppe 51 ist zweideutig das untere Frequenzband LB oder das mittlere Frequenzband MB, der dritten Gruppe 52 eindeutig das mittlere Frequenzband MB, der vierten Gruppe 53 zweideutig das mittlere Frequenzband MB oder das obere Frequenzband HB und der fünften Gruppe 54 das obere Frequenzband HB zugeordnet. Liegt das dem Tuner zugeführte Frequenzinformationssignal in der ersten Gruppe 50, der dritten 52 oder der fünften Gruppe 54, so trifft die Bandvorwahlschaltung eine endgültige Entscheidung über das diesem Frequenzinformationssignal zugeordnete Frequenzband. Bei Frequenzinformationssignalen der ersten Gruppe 50 wird der Tuner auf das untere Frequenzband LB geschaltet, bei der dritten Gruppe 52 wird der Tuner auf das mittlere Frequenzband MB geschaltet und bei der fünften Gruppe 54 wird der Tuner auf das obere Frequenzband HB geschaltet. In der zweiten Gruppe 51 wird der Tuner zunächst auf das untere Frequenzband LB geschaltet und es wird versucht, in dem unteren Frequenzband auf die gewünschte Frequenz abzustimmen. Ist der Tune-Versuch in dem unteren Frequenzband LB nicht erfolgreich, so schaltet der Tuner automatisch auf das mittlere Frequenzband MB um, und versucht, das in dem mittleren Frequenzband MB auf die gewünschte Frequenz abzustimmen. In analoger Weise wird bei Frequenzinformationssignalen der vierten Gruppe 53 zunächst versucht, die gewünschte Frequenz in dem mittleren Frequenzband zu tunen. Gelingt dies nicht, so schaltet der Tuner automatisch auf das obere Frequenzband HB um und versucht, die gewünschte Frequenz in diesem Frequenzband abzustimmen.

Die Software und die Steuerelektronik eines Tuners gemäß Fig. 3 kann für alle Tuner verwendet werden, deren Umschaltpunkte zwischen dem unteren Frequenzband LB und dem mittleren Frequenzband MB innerhalb der zweiten Gruppe 51 liegen und deren Umschaltpunkte zwischen dem mittleren Frequenzband MB und dem oberen Frequenzband HB im Bereich der vierten Gruppe 53 liegen. Die Grenzen der zweiten Gruppe 51 und der vierten Gruppe 53 sind so ausgelegt, daß sie die Umschaltpunkte zwischen den einzelnen Frequenzbändern aller handelsüblichen Tuner umfassen. Die Frequenzbandgrenzen der Gruppen 50 bis 54 können für andere Applikationen entsprechend abgeändert werden. Mittels der Aufteilung des gesamten Frequenzbandbereiches in die Gruppen 50 bis 54 läßt sich die Tune-Zeit deutlich verkürzen, da der zu durchsuchende Frequenzbandbereich deutlich verringert wird.

Fig. 4 zeigt eine alternative Aufteilung des Frequenzbandbereiches der terrestrischen Tuner, welche ebenfalls als Bandvorwahlschaltung in die integrierte Schaltung 5 gemäß Fig. 1 integrierbar ist. Gemäß Fig. 4 ist der gesamte Frequenzbandbereich in eine erste Gruppe 55, eine zweite Gruppe 56 und eine dritte Gruppe 57 aufgeteilt. Die erste Gruppe 55 umfaßt den Frequenzbandbereich von 45,25 MHz bis 175,25 MHz, die zweite Gruppe 56 den Frequenzbandbereich von 175,25 MHz bis 471,25 MHz und die dritte Gruppe 57 den Frequenzbandbereich von 471,25 MHz bis 863,25 MHz. Bei Frequenzinformationssignalen der ersten Gruppe 55 ist vorgesehen, bei einem neu einzustellenden Empfangskanal zunächst in das untere Frequenzband LB zu schalten und zu versuchen, die gewünschte Frequenz in diesem unteren Frequenzband LB zu tunen. Ist dies nicht möglich, so wird automatisch auf das mittlere Frequenzband MB umgeschaltet und der Tune-Vorgang wird dort wiederholt. Bei Frequenzinformationssignalen der zweiten Gruppe 56 ist vorgesehen, zunächst in dem mittleren Frequenzbereich MB das Tunen einer neu einzustellenden Frequenz zu versuchen. Ist dies nicht möglich, so schaltet der Tuner automatisch auf das obere Frequenzband HB um und versucht, die gewünschte Frequenz in dem oberen Frequenzband HB abzustimmen. Bei Frequenzinformationssignalen der dritten Gruppe 57 schaltet der Tuner sofort auf das obere Frequenzband HB. Eine automatische Frequenzumschaltung ist nicht vorgesehen. Diese Ausführungsform hat den Vorteil, daß die Bandvorwahlschaltung die Frequenzinformationssignale nur in drei Gruppen einteilen muß. Dies vereinfacht den Decoder. Die Grenzen der ersten, der zweiten und der dritten Gruppe können je nach Applikation geändert werden. Die Software und die Steuerelektronik eines Tuners mit einer Bandvorwahlschaltung gemäß Fig. 4 kann für alle Tuner verwendet werden, deren Umschaltpunkte zwischen dem unteren Frequenzband LB und dem mittleren Frequenzband MB sich innerhalb der ersten Gruppe 55 befinden und deren Umschaltpunkte zwischen dem mittleren Frequenzband MB und dem oberen Frequenzband HB sich in der zweiten Gruppe 56 befinden.

In dem Überlappungsbereich IV kann eine Frequenz sowohl in dem unteren Frequenzband LB als auch in dem mittleren Frequenzband MB getunt werden. Da in dem Überlappungsbereich IV das Rauschen und die Verstärkung in dem unteren Frequenzband LB günstiger ist, ist es vorteilhaft, ein sich dort befindliches Empfangssignal in dem unteren Frequenzband LB zu empfangen. In analoger Weise ist es günstiger, ein sich in dem Überlappungsbereich V befindliches Empfangssignal in dem mittleren Frequenzband MB zu empfangen. Daher ist es in der zweiten Gruppe 51 günstiger, den Tune-Vorgang zunächst in dem unteren Frequenzband LB zu beginnen und in der dritten Gruppe 53 ist es günstiger, den Tune-Vorgang in dem mittleren Frequenzband MB zu beginnen. Dadurch wird gewährleistet, daß in den Überlappungsbereichen IV und V vorzugsweise in dem jeweils niedrigeren Frequenzband empfangen wird

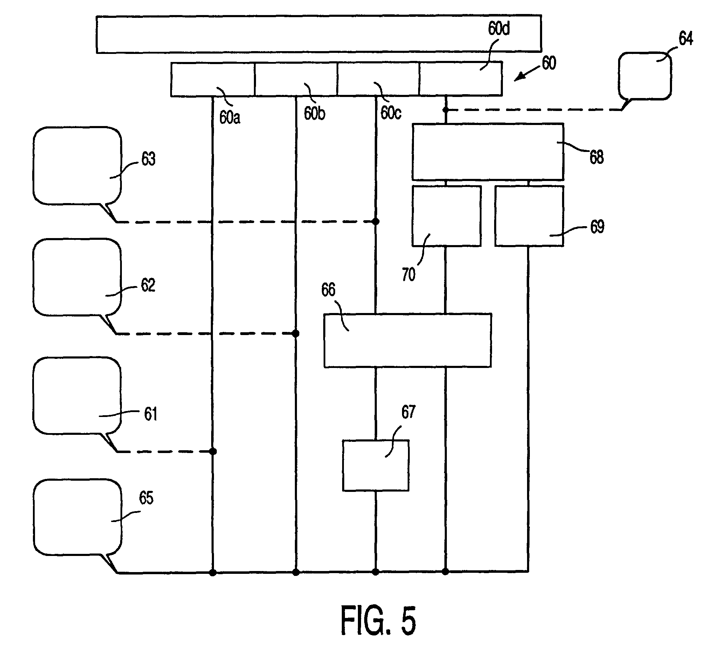

Fig. 5 zeigt ein Funktionsdiagramm der für die Auswahl des Frequenzbandes vorgesehenen Bandauswahlschaltung des Tuners, welche vorzugsweise in die integrierte Schaltung 5 gemäß Fig. 1 integriert ist. Gemäß Fig. 5 weist die Bandauswahlschaltung eine Frequenzdifferenzermittlungsschaltung 60 auf, welche, wenn dem Tuner ein neues Frequenzinformationssignal zugeführt wird, die Frequenzdifferenz zwischen dem alten Frequenzinformationssignal und dem neuen Frequenzinformationssignal bestimmt. Mittels der Frequenzdifferenzermittlungsschaltung 60 ist die Frequenzdifferenz zwischen dem alten und dem neuen Frequenzinformationssignal in einen ersten Frequenzdifferenzbereich 60a, einen zweiten Frequenzdifferenzbereich 60b, einen dritten Frequenzdifferenzbereich 60c und einen vierten Frequenzdifferenzbereich 60d aufteilbar. In dem ersten Frequenzdifferenzbereich 60a sind das alte und das neue Frequenzinformationssignal identisch und die Bandauswahlschaltung befindet sich im Erneuerungsmodus 61. Im Erneuerungsmodus 61 hat die Bandauswahlschaltung erkannt, daß dasselbe Frequenzinformationssignal nochmals dem Tuner zugeführt wurde. In einem derartigen Fall ist keine Frequenzbandumschaltung vorgesehen.

Daher geht die Bandauswahlschaltung in den Ende-Modus 65 über, in dem auf das Zuführen eines neuen Frequenzinformationssignals gewartet wird. In dem zweiten Frequenzdifferenzbereich unterscheidet sich das neue Frequenzinformationssignal von dem alten Frequenzinformationssignal nur geringfügig, vorzugsweise bei digital zugeführten Frequenzinformationssignalen nur um ein Bit. In einem solchen Fall befindet sich die Bandauswahlschaltung in einem automatischen Frequenzregelungsmodus 62, d.h. die Bandauswahlschaltung erkennt, daß das Fernsehgerät eine Frequenzfeinabstimmung des empfangenen Kanals vornimmt. In einem solchen Fall ist ebenfalls keine Frequenzbandumschaltung erwünscht und dementsprechend wird die Bandauswahlschaltung ebenfalls in den Ende-Modus 65 überführt. Der dritte Frequenzdifferenzbereich 60c ist einem Suchmodus 63 zugeordnet. Fernsehgeräte weisen einen derartigen Suchmodus auf, um die einzelnen Frequenzbänder systematisch nach empfangbaren Fernschkanälen zu durchsuchen. In einem solchen Fall erhöht der Mikroprozessor des Fernsehers das dem Tuner zugeführte Frequenzinformationssignal kontinuierlich in vorgebbaren Frequenzschritten. Die Größe dieser Frequenzschritte liegt typischerweise in einem Frequenzbereich von 62,5 kHz bis 1 MHz. Wird von dem Mikroprozessor des Fernsehers ein derartiger Suchmodus durchgeführt, so ist eine Frequenzbandumschaltung nur vorgesehen, wenn das Ende des jeweiligen Frequenzbandes erreicht ist. Im Suchmodus wird daher mittels eines Bandendetektors 66 überprüft, ob das Bandende des jeweiligen Frequenzbandes, in dem der Suchmodus gerade ausgeführt wird, erreicht ist. Dies kann beispielsweise durch Überwachung der Tune-Spannung erfolgen. Wird das Bandende mittels des Bandendedetektors 66 detektiert, so schaltet der Tuner auf das nächsthöhere Frequenzband um. Dies ist durch den Block 67 in Fig. 5 dargestellt. Als vierten Frequenzbereich unterscheidet die Frequenzdifferenzermittlungsschaltung 60 einen Frequenzdifferenzbereich 60d, wodurch der Tuner in einen Kanalneuwahlmodus 64 überführt wird. In diesem Kanalneuwahlmodus detektiert die Frequenzdifferenzermittlungsschaltung 60, daß dem Tuner ein Frequenzinformationssignal zugeführt wird, welches einem neu zu tunenden Kanal entspricht. Diese Erkennung wird dadurch realisiert, daß die Frequenzdifferenz zwischen dem alten und dem neuen Frequenzinformationssignal einen vorgebbaren Mindestabstand übersteigen muß. Bei terrestrischen Sendern beträgt der Abstand zwischen den einzelnen Kanälen üblicherweise 7 MHz. Der Schwellwert für den vierten Frequenzdifferenzbereich 60d ist daher etwas unterhalb dieses Kanalabstandes zu wählen, vorzugsweise bei ca. 5 MHz. Dies bedeutet, daß der Tuner bei neu zugeführten Frequenzinformationssignalen, welche um mindestens 5 MHz von dem alten Frequenzinformationssignal beabstandet sind, in den Kanalneuwahlmodus 64 übergeht. In dem Kanalneuwahlmodus 64 wird zunächst mittels einer Kanalvorwahlschaltung 68 eine Vorauswahl des Frequenzbandes getroffen. Die Kanalvorwahlschaltung 68 weist eine beispielsweise gemaß den Fig. 3 oder 4 ausgebildete Zuordnungsfunktion auf, welche das zugeführte Frequenzinformationssignal entweder eindeutig einem der Frequenzbändet zuordnet oder lediglich eine Vorauswahl trifft und gegebenenfalls eine Bandumschaltung vornimmt. Ist die Kanalvorwahlschaltung 68 beispielsweise gemäß Fig. 3 ausgebildet, so wird bei Frequenzinformationssignalen, die sich in der ersten Gruppe 50, der dritten Gruppe 52 oder der fünften Gruppe 54 befinden, eine eindeutige und endgültige Bandauswahl getroffen. Dies wird durch den Block 69 repräsentiert. Danach geht die Bandauswahlschaltung in den Ende-Modus 65 über und wartet auf ein neu zugeführtes Frequenzinformationssignal. Befinden sich die dem Tuner zugeführten Frequenzinformationssignale jedoch in der zweiten Gruppe 51 oder der vierten Gruppe 53, so wird in dem Block 70 nur eine Vorauswahl des Frequenzbandes getroffen, d.h. bei der zweiten Gruppe 51 wird auf das untere Frequenzband LB geschaltet und bei der vierten Gruppe 53 auf das mittlere Frequenzband MB. Ist das Tunen bei der zweiten Gruppe 51 in dem unteren Frequenzband LB nicht möglich, so wird dies mittels des Bandendedetektors 66 detektiert und im Block 67 wird eine Bandumschaltung auf das mittlere Frequenzband MB vorgenommen. In analoger Weise wird bei der vierten Gruppe 53 zunächst versucht, in dem mittleren Frequenzband MB zu tunen. Falls dies nicht möglich ist, wird es mittels des Bandendedetektors 66 detektiert und in dem Block 67 auf das obere Frequenzband HB umgeschaltet.

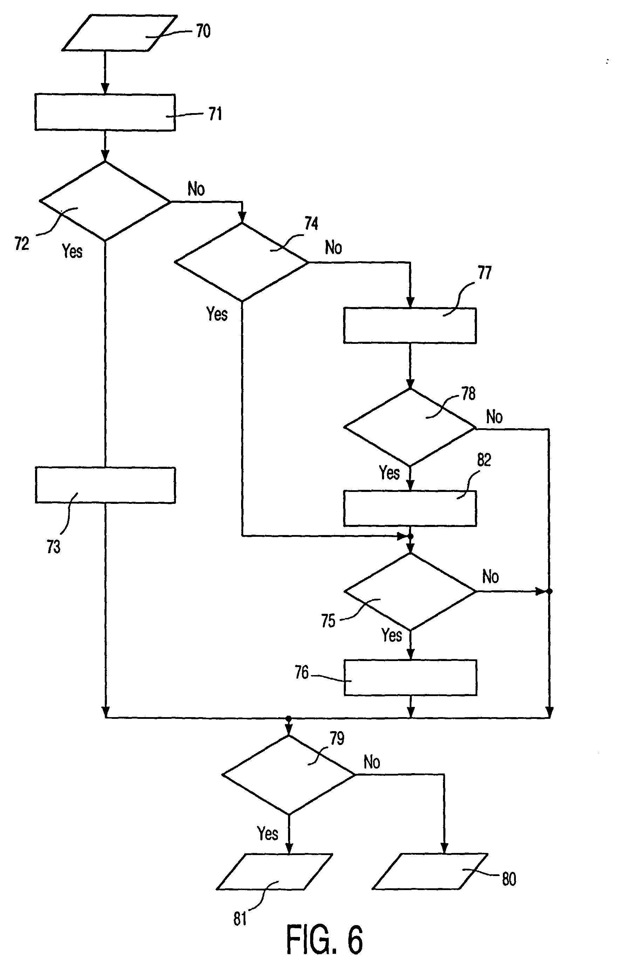

Fig. 6 zeigt ein prinzipielles Flussablaufdiagramm des Vorganges der Bandauswahl, wenn dem Tuner ein neues Frequenzinformationssignal zugeführt wird. Der Block 70 repräsentiert den Start, d.h., daß dem Tuner ein neues Frequenzinformationssignal zugeführt wird. In dem nachfolgenden Block 71 wird das dem Tuner neu zugeführte Frequenzinformationssignal mit dem alten Frequenzinformationssignal verglichen und die Frequenzdifferenz ermittelt. Danach wird in dem Block 72 überprüft, ob die ermittelte Differenzfrequenz einerseits dem Erneuerungsmodus oder dem automatischen Frequenzregelungsmodus oder andererseits dem Suchmodus oder dem Kanalneuwahlmodus zugeordnet werden muß. Dies wird mittels einer Schwellwertüberprüfung realisiert, d.h. es wird überprüft, ob sich die Frequenzdifferenz unterhalb eines ersten Schwellwertes befindet oder oberhalb dieses ersten Schwellwertes. Der erste Schwellwert ist so zu legen, daß unterhalb dieses Schwellwertes die Frequenzdifferenzen des automatischen Frequenzregelungsmodus liegen und oberhalb des Schwellwertes die Frequenzen des Suchmodus und des Kanalneuwahlmodus. Wird im Block 72 erkannt, daß sich das Frequenzdifferenzinformationssignal unterhalb des ersten Schwellwertes befindet, so wird zu dem Block 73 gewechselt, welcher repräsentiert, daß keine Bandumschaltung vorgesehen ist. Wird im Block 72 festgestellt, daß das zugeführte Frequenzdifferenzsignal oberhalb des ersten Schwellwertes liegt, so wird in dem Block 74 überprüft, ob die Frequenzdifferenz unterhalb oder oberhalb eines zweiten Schwellwertes liegt. Dieser zweite Schwellwert ist so gewählt, daß er eine Unterscheidung zwischen dem Suchmodus und dem Kanalneuwahlmodus ermöglicht. Liegt das Frequenzdifferenzsignal unterhalb des zweiten Schwellwertes, so befindet sich der Tuner im Suchmodus und es wird direkt zu dem Block 75 übergegangen, in dem überprüft wird, ob das Bandende des jeweils eingeschalteten Frequenzbandes erreicht ist. Ist dies der Fall, so wird in dem Block 76 auf das nächsthöhere Frequenzband umgeschaltet. Anderenfalls ist keine Frequenzbandumschaltung vorgesehen. Wird in dem Block 74 festgestellt, daß das Frequenzdifferenzsignal oberhalb des zweiten Schwellwertes liegt, so befindet sich der Tuner im Kanalneuwahlmodus und in dem Block 77 wird mittels einer Bandvorwahlschaltung eine Bandvorauswahl getroffen, d.h. beispielsweise bei einer Vorwahlschaltung gemäß Fig. 3 wird das Frequenzdifferenzsignal einer der fünf Gruppen 50 bis 54 zugeordnet und das dieser Gruppe zugeordnete Frequenzband eingeschaltet. Im nachfolgenden Block 78 wird überprüft, ob es sich bei der im Block 77 ermittelten Gruppe um eine eindeutige oder mehrdeutige Gruppe handelt, d.h. ob das Frequenzinformationssignal innerhalb der ersten Gruppe 50, der dritten Gruppe 52 oder der fünften Gruppe 54 liegt, denen jeweils eindeutig ein Frequenzband zugeordnet ist, oder ob das Frequenzinformationssignal innerhalb der zweiten Gruppe 51 oder der vierten Gruppe 53 liegt, denen zweideutig zwei Frequenzbänder zugeordnet sind. Im ersteren Fall, d.h. bei den eindeutigen Gruppen 50, 52 und 54 ist keine weitere Bandumschaltung vorgesehen und es wird direkt zu dem Block 79 übergegangen. In dem Block 79 wird überprüft, ob der PLL-Oszillator des Tuners auf die gewünschte Empfangsfrequenz eingerastet ist. Ist dies nicht der Fall, wird im Block 80 eine Fehlermeldung ausgegeben. War das Einrasten auf die gewünschte Empfangsfrequenz erfolgreich, so wird im Block 81 der Tune-Vorgang erfolgreich beendet. Wird im Block 78 festgestellt, daß sich das Frequenzinformationssignal bei dem Beispiel gemäß Fig. 3 in der zweiten Gruppe 51 oder der vierten Gruppe 53 befindet, so wird in dem Block 82 zunächst auf das niedrigere der beiden Frequenzbänder geschaltet, d.h. bei der zweiten Gruppe 51 auf das untere Frequenzband LB und bei der vierten Gruppe 53 auf das mittlere Frequenzband MB. Danach ist in dem Block 75 eine Überprüfung vorgesehen, ob das Frequenzbandende erreicht ist. Ist dies nicht der Fall, so ist keine Bandumschaltung vorgesehen. Wird das Frequenzbandende im Block 75 detektiert, so wird im nachfolgenden Block 76 auf das nächsthöhere Frequenzband umgeschaltet, d.h. bei der zweiten Gruppe 51 auf das mittlere Frequenzband MB und bei der vierten Gruppe 53 auf das obere Frequenzband HB. Danach wird im Block 79 überprüft, ob der PLL-Oszillator auf die gewünschte Empfangsfrequenz eingerastet ist. Im positiven Fall wird der Tune-Vorgang mit dem Block 81 erfolgreich beendet. Im negativen Fall wird im Block 80 eine Fehlermeldung ausgegeben.

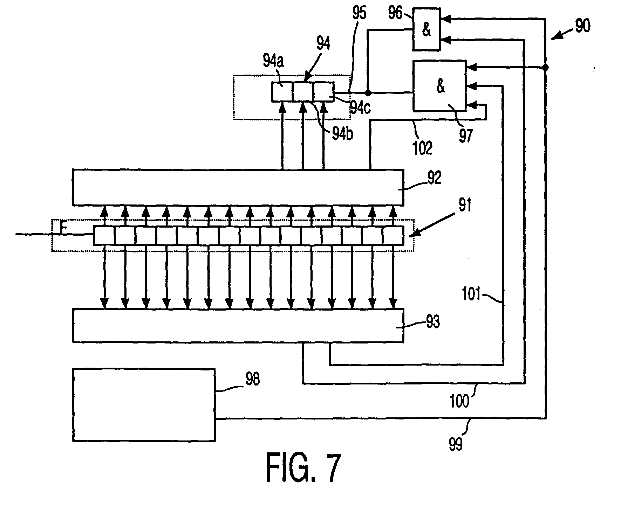

Fig. 7 zeigt eine hardwaremäßige Implementierung einer Bandauswahlschaltung 90. Die Bandauswahlschaltung 90 weist ein Eingangsregister 91 auf welchem ein Frequenzinformationssignal F in digitaler Form über beispielsweise einen I²C-Bus des Fernsehgerätes zuführbar ist. Das Eingangsregister 91 weist 14 Speicherplätze zur digitalen Speicherung des Frequenzinformationssignales F auf. Das Eingangsregister 91 ist einerseits mit einer Bandvorwahlschaltung 92 und andererseits mit einer Frequenzdifferenzermittlungsschaltung 93 gekoppelt. Die in dem Eingangsregister 91 gespeicherte Frequenzinformation wird parallel der Bandvorwahlschaltung 91 und der Frequenzdifferenzermittlungsschaltung 93 zugeführt. In der Bandvorwahlschaltung 92 ist eine Frequenzzuordnungstabelle implementiert, wie sie beispielsweise in den Fig. 3 und 4 beschrieben ist. Das mittels der Bandvorwahlschaltung 92 ausgewählte Frequenzband wird in digitaler Form in ein Schieberegister 94 geschrieben. Das Schieberegister 94 weist ein erstes Speicherfeld 94a, ein zweites Speicherfeld 94b und ein drittes Speicherfeld 94c auf. Das Speicherfeld 94a ist als Steuerinformation für das untere Frequenzband LB, das zweite Speicherfeld 94b als Steuerinformation für das mittlere Frequenzband MB und das dritte Speicherfeld 94c als Steuerinformation für das obere Frequenzband HB vorgesehen. Das Schieberegister 94 ist zyklisch ausgebildet, d.h. die Speicherinformation des ersten Speicherfeldes 94a wird bei dem nächsten Verschiebetakt in das dritte Speicherfeld 94c eingeschrieben. Die Frequenzdifferenzermittlungsschaltung 93 ermittelt die Frequenzdifferenz zwischen dem alten und dem neuen Frequenzinformationssignal F. Die Ansteuerung des Schieberegisters 94 erfolgt über eine Steuerleitung 95, welche mit dem Ausgang einer UND-Schaltung 96 und mit dem Ausgang einer UND-Schaltung 97 gekoppelt ist. Die Bandauswahlschaltung 90 weist als Bandendedetektor einen Tune-Spannungs-Komparator 98 auf, welcher die Tune-Spannung, mittels derer das Bandpassfilter und der Oszillator des jeweiligen Frequenzbandes angesteuert wird, mit einer Referenzspannung vergleicht. Liegt die Tune-Spannung oberhalb dieser Referenzspannung, so erzeugt der Tune-Spannungs-Komparator 98 ein positives Steuerbit 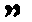 1" und liefert dieses über eine Steuerleitung 99 einerseits an den Eingang der UND-Schaltung 96 und andererseits an den Eingang UND-Schaltung 97. Die Frequenzdifferenzermittlungsschaltung 93 liefert über eine Steuerleitung 100 ein positives Steuerbit "1" an die UND-Schaltung 96, wenn das ermittelte Frequenzdifferenzsignal beispielsweise in einem Bereich von 2 bis 16 digitalen Frequenzschritten liegt. Dies entspricht dem Suchmodus. Die Frequenzdifferenzermittlungsschaltung 93 liefert ein positives Steuerbit 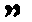 1" an die UND-Schaltung 97, wenn die mittels der Frequenzdifferenzermittlungsschaltung ermittelte Frequenzdifferenz beispielsweise größer als 80 digitale Frequenzschritte ist. In diesem Fall handelt es sich um einen neu einzustellenden Kanal. Die Bandvorwahlschaltung 92 liefert über eine Steuerschaltung 102 ein positives Steuerbit 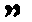 1" an die UND-Schaltung 97, wenn sich die Frequenz des zugeführten Frequenzinformationssignals in einer nicht eindeutigen Gruppe befindet, d.h. beispielsweise bei einer Bandvorwahlschaltung gemäß Fig. 3 in der zweiten Gruppe 51 oder in der vierten Gruppe 53. In einem derartigen Fall muß gegebenenfalls bei erfolgloser Suche in dem zunächst ausgewählten Frequenzband auf das nächsthöhere Frequenzband umgeschaltet werden. Die UND-Schaltung 96 liefert nur dann ein Steuersignal zur Bandumschaltung an das Schieberegister 94, wenn mittels des Tune-Spannungs-Komparators über die Steuerleitung 99 das Bandende signalisiert wird, d.h. wenn das Ende des jeweiligen Frequenzbandes erreicht ist, und wenn die Frequenzdifferenzermittlungsschaltung 93 über die Steuerleitung 100 signalisiert, daß das neu zugeführte Frequenzsignal dem Suchmodus zugeordnet ist, d.h. daß das Fernsehgerät sukzessive die Frequenzbänder nach empfangbaren Kanälen durchsucht.

Die UND-Schaltung 97 liefert nur dann ein Steuersignal zur Bandumschaltung an das Schieberegister 94, wenn mittels des Tune-Spannungs-Komparators über die Steuerleitung 99 das Bandende signalisiert wird, wenn die Frequenzdifferenzermittlungsschaltung 93 über die Steuerleitung 101 signalisiert, daß das neu zugeführte Frequenzsignal einem neuen Empfangskanal entspricht und wenn gleichzeitig die Bandvorwahlschaltung 92 über die Steuerleitung 102 signalisiert, daß das neu zugeführte Frequenzinformationssignal in einem mehrdeutigen Bereich liegt, in dem gegebenenfalls eine Bandumschaltung erforderlich ist.

## Patentansprüche

1. Tuner mit wenigstens einem ersten (1) und einem zweiten (2) Frequenzband und mit einem Signaleingang (7) zum Zuführen eines Frequenzinformationssignals,
dadurch gekennzeichnet,
daß der Tuner eine Bandauswahlschaltung (90) aufweist, welche zur Auswahl und Ansteuerung jeweils eines Frequenzbandes (1, 2, 3) vorgesehen ist und daß der Tuner zum Abstimmen auf eine Frequenz eine Frequenzsuchfunktion aufweist, welche in einem ersten Schritt zur Überprüfung der Abstimmbarkeit der Frequenz in dem ersten Frequenzband (1) vorgesehen ist und, falls die Abstimmung in dem ersten Frequenzband nicht möglich ist, in einem zweiten Schritt zur Überprüfung der Abstimmbarkeit der Frequenz in dem zweiten Frequenzband (2) vorgesehen ist.

2. Tuner nach Anspruch 1,
dadurch gekennzeichnet,
daß die Bandauswahlschaltung (90) eine Frequenzdifferenzermittlungsschaltung (93) aufweist, welche dazu vorgesehen ist, bei neu zugeführten Frequenzinformationssignalen die Differenzfrequenz zwischen dem alten und dem neuen Frequenzinformationssignal zu ermitteln und in Abhängigkeit der ermittelten Differenzfrequenz einen die Bandauswahl beeinflussenden Tune-Modus auszuwählen.

3. Tuner nach Anspruch 1,
dadurch gekennzeichnet,
daß die Bandauswahlschaltung (90) zum Einstellen einer neuen Frequenz eine Bandvorwahlschaltung (92) aufweist, welche zur Vorauswahl des Frequenzbandes (1, 2, 3) in Abhängigkeit des Frequenzinformationssignals vorgesehen ist, wobei die Bandvorwahlschaltung (92) zur Unterscheidung zwischen eindeutigen Frequenzinformationssignalen, welche eindeutig einem Frequenzband (1, 2, 3) zuordbar sind, und mehrdeutigen Frequenzinformationssignalen, welche nicht eindeutig einem Frequenzband (1, 2, 3) zuordbar sind, vorgesehen ist, wobei im Falle mehrdeutiger Frequenzinformationssignale in einem ersten Schritt die Überprüfung der Abstimmbarkeit der Frequenz in dem ersten Frequenzband (1) vorgesehen ist und, falls die Abstimmung in dem ersten Frequenzband (1) nicht möglich ist, in einem zweiten Schritt die Überprüfung der Abstimmbarkeit der Frequenz in dem zweiten Frequenzband (2) vorgesehen ist.

4. Tuner nach Anspruch 2,
dadurch gekennzeichnet,
daß mittels der Frequenzdifferenzermittlungsschaltung (93) als Tune-Modi ein Erneuerungsmodus (61) und/oder ein automatischer Frequenzregelungsmodus (62) und/oder ein Suchmodus (63) und/oder ein Kanalneuwahlmodus (64) unterscheidbar sind, daß als Erneuerungsmodus (61) das erneute Zuführen desselben Frequenzinformationssignals vorgesehen ist, daß als automatischer Frequenzregelungsmodus (62) das Zuführen eines nur geringfügig geänderten Frequenzinformationssignals zur automatischen Frequenzfeinabstimmung einer eingestellten Frequenz vorgesehen ist, daß als Suchmodus (63) das aufeinanderfolgende Zuführen jeweils um eine vorgebbare Frequenz erhöhter Frequenzinformationssignale zum Durchsuchen eines oder mehrerer Frequenzbänder (1, 2, 3) nach empfangbaren Kanälen vorgesehen ist und daß als Frequenzneuwahlmodus (64) das Zuführen eines Frequenzinformationssignals eines neuen Kanals vorgesehen ist,
wobei im Erneuerungsmodus (61) und im automatischen Frequenzregelungsmodus (62) keine Frequenzbandänderung vorgesehen ist, wobei im Suchmodus (63) eine Frequenzbandänderung nur bei Erreichen des Frequenzbandendes vorgesehen ist und wobei im Kanalneuwahlmodus (64) die Frequenzbandeinstellung mittels der Frequenzsuchfunktion vorgesehen ist.

5. Tuner nach Anspruch 3,
dadurch gekennzeichnet,
daß die Bandvorwahlschaltung (92) zur Unterscheidung der Frequenzinformationssignale in wenigstens zwei Gruppen vorgesehen ist, daß die erste Gruppe die Frequenzinformationssignale umfaßt, die eindeutig dem ersten Frequenzband (1) und zweideutig dem ersten (1) oder dem zweiten (2) Frequenzband zuordbar sind, daß die zweite Gruppe die Frequenzinformationssignale umfaßt, die eindeutig dem zweiten Frequenzband (2) zuordbar sind und daß für die erste Gruppe in einem ersten Schritt die Überprüfung der Abstimmbarkeit der Frequenz in dem ersten Frequenzband (1) vorgesehen ist und, falls die Abstimmung in dem ersten Frequenzband (1) nicht möglich ist, in einem zweiten Schritt die Überprüfung der Abstimmbarkeit der Frequenz in dem zweiten Frequenzband (2) vorgesehen ist.

6. Tuner nach Anspruch 3,
dadurch gekennzeichnet,
daß die Bandvorwahlschaltung (92) zur Unterscheidung der Frequenzinformationssignale in wenigstens drei Gruppen vorgesehen ist, daß die erste Gruppe die Frequenzinformationssignale umfaßt, die eindeutig dem ersten Frequenzband (1) zuordbar sind, daß die zweite Gruppe die Frequenzinformationssignale umfaßt, die zweideutig dem ersten (1) oder dem zweiten (2) Frequenzband zuordbar sind, daß die dritte Gruppe die Frequenzinformationssignale umfaßt, die eindeutig dem zweiten Frequenzband (2) zuordbar sind und daß für die zweite Gruppe in einem ersten Schritt die Überprüfung der Abstimmbarkeit der Frequenz in dem ersten Frequenzband (1) vorgesehen ist und, falls die Abstimmung in dem ersten Frequenzband (1) nicht möglich ist, in einem zweiten Schritt die Überprüfung der Abstimmbarkeit der Frequenz in dem zweiten Frequenzband (2) vorgesehen ist.

7. Tuner nach Anspruch 1,
dadurch gekennzeichnet,
daß die Bandauswahlschaltung (90) einen Bandendedetektor (98) aufweist, welcher zur Auswertung der Tune-Spannung der Abstimmkapazität des jeweiligen Frequenzbandes (1, 2, 3) vorgesehen ist und welcher bei Überschreiten eines vorgebbaren Schwellwertes zur Lieferung eines Steuersignals vorgesehen ist.

8. Tuner nach Anspruch 7,
dadurch gekennzeichnet,
daß die Bandauswahlschaltung (90) zur Ansteuerung der Frequenzbänder (1, 2, 3) ein zyklisches Schieberegister (40; 94) mit n-Elementen aufweist, wobei n der Anzahl der Frequenzbänder (1, 2, 3) des Tuners entspricht, daß jedes der n-Elemente als Steuerinformation für jeweils eines der n-Frequenzbänder vorgesehen ist, daß das Schieberegister (40; 94) mittels des Steuersignals des Bandendedetektors (98) ansteuerbar ist und daß bei Detektion des Bandendes ein serielles Weiterschieben der Steuerinformation des Schieberegisters (40; 94) und eine daraus resultierende Bandumschaltung auf das nächste Frequenzband vorgesehen ist.

9. Tuner nach Anspruch 1,
dadurch gekennzeichnet,
daß das erste Frequenzband (1), welches mittels der Frequenzsuchfunktion in dem ersten Schritt durchsucht wird, hinsichtlich der Frequenzhöhe unterhalb des zweiten Frequenzbandes (2) liegt.

10. Integrierte Schaltung (5) mit einem PLL-Schaltkreis zur Steuerung eines wenigstens ein erstes (1) und ein zweites (2) Frequenzband aufweisenden Tuners,
dadurch gekennzeichnet,
daß die integrierte Schaltung (5) eine Bandauswahlschaltung (90) aufweist, welche zur Lieferung von Steuersignalen zur Auswahl jeweils eines Frequenzbandes (1, 2, 3) vorgesehen ist und daß die Bandauswahlschaltung (90) zum Abstimmen auf eine Frequenz eine Frequenzsuchfunktion aufweist, welche in einem ersten Schritt zur Überprüfung der Abstimmbarkeit der Frequenz in dem ersten Frequenzband (1) vorgesehen ist und, falls die Abstimmung in dem ersten Frequenzband (1) nicht möglich ist, in einem zweiten Schritt zur Überprüfung der Abstimmbarkeit der Frequenz in dem zweiten Frequenzband (2) vorgesehen ist.

11. Fernsehgerät mit einem Tuner nach einem der Ansprüche 1 bis 9.
